# EUROPÄISCHE PATENTANMELDUNG

(11) **EP 1 708 346 A2**
(43) Veröffentlichungstag der Anmeldung: **04.10.2006**
(21) Anmeldenummer: 06004493.0
(22) Anmeldetag: 06.03.2006
(51) Int. Cl.: H02M 3/335

(54) **Aktive primärseitige Schaltungsanorndung für ein schaltnetzteil**

(30) Priorität: 31.03.2005 DE 102005014746
(71) Anmelder: Friwo Mobile Power GmbH, 48346 Ostbevern (DE)
(72) Erfinder: Mörbe, Stefan, 49205 Hasbergen (DE); Bothe, Michael, 48163 Münster (DE)
(74) Vertreter: Grünecker, Kinkeldey, Stockmair & Schwanhäusser Anwaltssozietät

(57) **Zusammenfassung**

Die vorliegende Erfindung bezieht sich auf eine Schaltungsanordnung für ein Schaltnetzteil, wobei das Schaltnetzteil eine Primärseite, die mit einer Versorgungsspannung verbindbar ist, und eine Sekundärseite, die mit einem Verbraucher verbindbar ist, aufweist, und wobei die Schaltungsanordnung einen primärseitigen Schalter, eine Ansteuerschaltung zum Ansteuern des primärseitigen Schalters und weitere aktive primärseitige Komponenten umfasst. Weiterhin bezieht sich die vorliegende Erfindung auch auf ein Schaltnetzteil mit einer derartigen aktiven primärseitigen Schaltungsanordnung. Um eine verbesserte Schaltungsanordnung anzugeben, welche die Nachteile der bekannten Lösungen überwindet und es ermöglicht, ein Schaltnetzteil in miniaturisierter Form auf besonders einfache und kostengünstige Weise aufzubauen und dabei die geltenden Sicherheitsnormen einzuhalten, ist die Ansteuerschaltung durch einen ersten integrierten Halbleiterchip gebildet und der primärseitige Schalter sowie die weiteren Komponenten sind in mindestens einem von der Ansteuerschaltung getrennten weiteren Halbleiterchip integriert, der mit der Ansteuerschaltung auf einem gemeinsamen Schaltungsträger angeordnet ist.

## Beschreibung

Die vorliegende Erfindung bezieht sich auf eine Schaltungsanordnung für ein Schaltnetzteil, wobei das Schaltnetzteil eine Primärseite, die mit einer Versorgungsspannung verbindbar ist, und eine Sekundärseite, die mit einem Verbraucher verbindbar ist, aufweist, und wobei die Schaltungsanordnung einen primärseitigen Schalter, eine Ansteuerschaltung zum Ansteuern des primärseitigen Schalters und weitere aktive primärseitige Komponenten umfasst. Weiterhin bezieht sich die vorliegende Erfindung auch auf ein Schaltnetzteil mit einer derartigen aktiven primärseitigen Schaltungsanordnung.

Ladegeräte im Kleinleistungsbereich werden heute üblicherweise als Schaltnetzteile realisiert. Durch die kleine Bauform und das geringe Gewicht haben diese sich in vielen Anwendungsfällen durchgesetzt und verdrängen die althergebrachten Lineargeräte. Die für ein Schaltnetzteil benötigte Elektronik ist trotz fortschreitender Integration der einzelnen Schaltungskomponenten, wie beispielsweise in Form anwenderspezifischer integrierter Schaltungen, sogenannter ASICs (Application Specific Integrated Circuit), immer noch vergleichsweise komplex und die primärseitige Schaltungsanordnung eines derartigen Schaltnetzteils besteht aus mehr als 20 einzelnen Schaltungskomponenten.

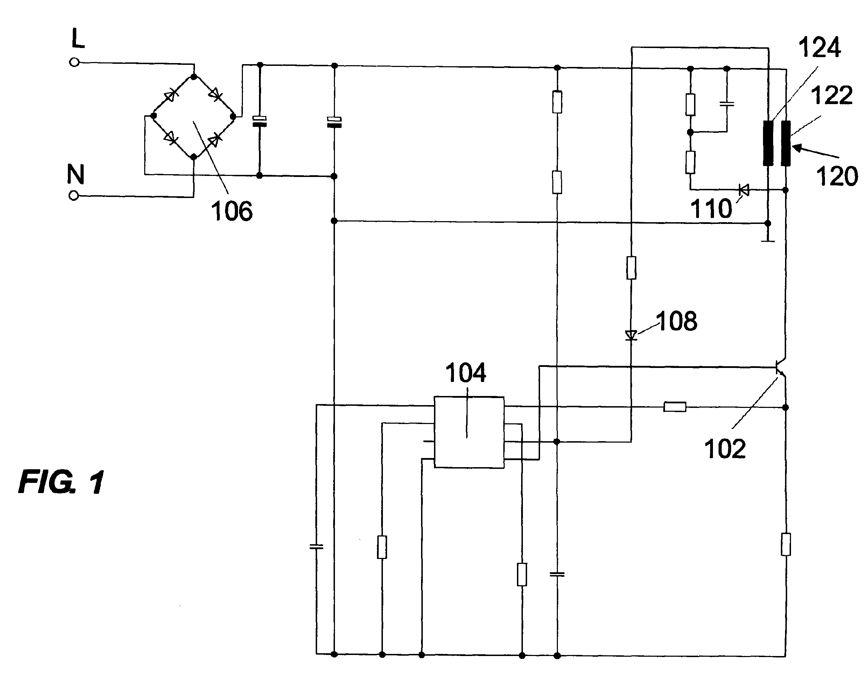

Figur 1 zeigt in Form eines Stromlaufplans das Schaltbild der Primärseite eines Schaltnetzteils mit Primärregelung. Dabei lassen sich die insgesamt 24 Komponenten wie folgt zuordnen: ein Wandlertransformator 120, bei dem nur die primärseitige Wicklung 122 und die Hilfswicklung 124 dargestellt sind, 16 Passivkomponenten, wie Widerstände, Induktivitäten und Kapazitäten, und bis zu acht Aktivkomponenten. Die Aktivkomponenten bilden die aktive primärseitige Schaltungsanordnung des Schaltnetzteils und umfassen vier Einzeldioden, welche einen Brückengleichrichter 106 bilden, den Schalttransistor 102, als Ansteuerschaltung 104 des primärseitigen Schalters 102 einen ASIC zur Pulsweitenmodulationsansteuerung des primärseitigen Schalttransistors, eine Hilfsspannungsdiode 108 und eine Snubber-Diode 110.

Um den Platzbedarf der Einzelkomponenten zu reduzieren, existieren gegenwärtig verschiedene Ansätze, die meist jedoch nicht weitreichend genug sind und sich nur über wenige Bauteile erstrecken.

Beispielsweise werden im Bereich der Passivkomponenten verschiedene Widerstände und auch RC-Funktionen in einem Bauteile-Array integriert.

Aus der US-amerikanischen Patentschrift US 6,134,123 ist weiterhin bekannt, bei einem Schaltnetzteil den primärseitigen Schalter und die Ansteuerschaltung auf einem gemeinsamen Substrat unterzubringen und als hybriden IC herzustellen.

Allerdings besteht bei der in dieser Druckschrift offenbarten Lösung der Nachteil, dass ein Großteil der platzbeanspruchenden Bauteile, wie der Gleichrichter oder die Hilfsspannungs- und Snubber-Diode, immer noch als externe Bauteile vorgesehen sind. Daher wird durch diese bekannte Lösung zwar eine erhöhte Stabilität des Schaltnetzteils durch die räumliche Nähe der Ansteuerschaltung und des primärseitigen Schalters erreicht, bezüglich der Miniaturisierung eines derartigen Schaltnetzteils werden aber keine weitergehenden Vorteile erzielt.

Weiterhin ist aus der US 5,355,301 ein Schaltnetzteil bekannt, bei dem ein gedruckter Wandler verwendet wird. Die aktiven Komponenten, d. h. der Brückengleichrichter, der primärseitige Schalter, die Ansteuerschalter und die Sekundärdiode sind hier in einem einzigen Chip integriert und zusammen mit dem gedruckten Wandler in einem gemeinsamen Substrat aufgebaut. Die Kontaktierung zwischen diesem Aktivchip und dem spannungswandelnden Bereich wird über eine weitere Verdrahtungslage bewerkstelligt. Dabei werden die Kontaktierungen zu dem Aktivchip über entsprechende Öffnungen in dem Chip hergestellt. Das Aktivbauteil ist also Bestandteil eines voll integrierten Schaltnetzteils und wird nicht als separater IC in einem eigenen IC-Gehäuse hergestellt.

Die hier gezeigte Lösung hat daher zum einen den Nachteil, dass die mitintegrierte Sekundärdiode eine Primär/Sekundärtrennung nach den geltenden Normen nicht ermöglicht. Darüber hinaus stellt die technische Lösung eines vollständig integrierten Schaltnetzteils eine sehr aufwendige Konzeption dar, die nur mit großen Herstellungskosten verwirklicht werden kann.

Neben der erwähnten Komplexität der Komponenten erfordert die Herstellung der bekannten Schaltnetzteile außerdem eine komplexe Logistik für die Beschaffung der Einzelkomponenten und für die Fertigung substantielle Investitionen in Bestückungsautomaten und Testtechnik.

Es besteht daher ein Bedürfnis, eine verbesserte Schaltungsanordnung anzugeben, welche die Nachteile der bekannten Lösungen überwindet und es ermöglicht, ein Schaltnetzteil in miniaturisierter Form auf besonders einfache und kostengünstige Weise aufzubauen und dabei die geltenden Sicherheitsnormen zu erfüllen.

Diese Aufgabe wird durch den Gegenstand des Patentanspruchs 1 gelöst. Vorteilhafte Weiterbildungen der vorliegenden Erfindung sind Gegenstand mehrerer abhängiger Ansprüche.

Die vorliegende Erfindung basiert auf der Idee, dass bei einem primärseitigen Schaltnetzteil eine Schaltungsanordnung, die den primärseitigen Schalter, eine Ansteuerschaltung zum Ansteuern des primärseitigen Schalters und weitere aktive primärseitige Komponenten umfasst, so ausgeführt ist, dass die Ansteuerschaltung durch einen ersten integrierten Halbleiterchip gebildet ist und der primärseitige Schalter sowie die weiteren Komponenten in mindestens einem von der Ansteuerschaltung getrennten weiteren Halbleiterchip integriert sind, der mit der Ansteuerschaltung auf einem gemeinsamen Schaltungsträger angeordnet ist.

Auf diese Weise kann mit Hilfe einer erfindungsgemäßen Schaltungsanordnung in Form eines Moduls eine Vielzahl von aktiven Komponenten zusammengefasst werden, die in einer Primärschaltung eines Schaltnetzteils vorkommen. Es sind dies der Eingangsgleichrichter für die 50/60 Hz-Spannung, der Schalttransistor, die Ansteuerschaltung sowie Dioden für die Snubber-Schaltung und die Hilfsspannungsversorgung.

Dabei sind die aktiven Komponenten nicht wie üblich in diskreter Bauweise ausgeführt, sondern auf einem gemeinsamen Schaltungsträger aufgebaut und gemäß einer vorteilhaften Weiterbildung in einem gemeinsamen IC-Gehäuse untergebracht. Dadurch ergibt sich eine erhebliche Verringerung des Platzbedarfs sowie eine Minderung möglicher Fehlereinflüsse durch fehlerhafte Kontaktierungen der einzelnen Bauteile zu einem weiteren Schaltungsträger, beispielsweise einer Leiterplatte. Weiterhin entstehen während des Fertigungsprozesses Vorteile durch einen erheblich verringerten Logistikaufwand bei der Beschaffung von Bauteilen. Durch die Zusammenfassung zu einem einzigen Bauteil wird auch der Aufwand für die Bestückung und somit die Investitionen in die Fertigung verringert.

Vergleicht man bekannte, in diskreter Bauweise aufgebaute Schaltungsanordnungen mit einer Realisierung gemäß der vorliegenden Erfindung, so beträgt der minimale Flächenbedarf diskret aufgebauter Einzelkomponenten ca. 100 mm², wobei die ebenfalls erforderlichen elektrischen Verbindungen zwischen diesen Bauteilen nicht berücksichtigt sind. Das erfindungsgemäße integrierte Modul kann aber mit Abmessungen von 5x5 mm² oder darunter realisiert werden und somit wird nur ein Viertel der Fläche herkömmlicher Schaltungsanordnungen beansprucht.

Weiterhin kann mit der erfindungsgemäßen Schaltungsanordnung auch eine Reduzierung der Bauhöhen gegenüber Einzelkomponenten erzielt werden. Die einzelnen Halbleiterchips werden nebeneinander angeordnet, so dass eine geringere Bauhöhe die Folge ist. Der zusätzliche Platzbedarf für diese Anordnung in einer Ebene wird durch die Integration der aktiven Komponenten und die damit verbundenen Flächenersparnis mehr als ausgeglichen. Während die Bauhöhe von Einzelbauteilen bis zu 3 mm beträgt, kann bei Integration aller Bauteile beispielsweise in ein sogenanntes MLP-Gehäuse (Micro Lead Frame Package) eine Höhe von nur 1 mm erreicht werden.

Die erfindungsgemäße Schaltungsanordnung kann dabei entweder in einem bedrahteten Gehäuse oder aber in einem oberflächenmontierbaren Gehäuse für die Surface-Mount-Technologie (SMT) ausgeführt sein. Dabei sind die bedrahteten Bauelemente mit der herkömmlichen Durchsteckmontagetechnik (THT, Through Hole Technology) kompatibel, während bei einer Ausführung als SMD (Surface Mounted Device), also oberflächenmontiertes Bauelement, die Vorteile dieser stark miniaturisierten Technik ausgeschöpft werden können.

Bei dieser geringen Bauhöhe ist außerdem in vorteilhafter Weise eine beidseitige Kühlung des Schaltungsmoduls möglich. So kann die Metallisierung eines Leadframes nach unten direkt auf die Leiterplatte hinausgeführt werden. Durch die geringe Höhe und die damit verbundene gute Wärmeleitung durch das Gehäuse bringt auch eine Kühlung auf der Oberfläche signifikante Vorteile.

Weiterhin kann durch eine fortgesetzte monolithische Integration der verwendeten Bauteile eine zusätzliche Miniaturisierung der Schaltungsanordnung erreicht werden und es kann die Anzahl der elektrischen Verbindungen zwischen den Bauteilen verringert und somit die Zuverlässigkeit des gesamten Bauteils gesteigert werden.

Ein weiterer Vorteil der erfindungsgemäßen Lösung besteht in der Verringerung parasitärer Induktivitäten, die durch Verbindungen zwischen den diskreten Bauteilen entstehen. Da sich die Distanzen zwischen den Bauteilen gegenüber der diskreten Version stark reduzieren, werden die parasitären Induktivitäten der elektrischen Verbindungen stark reduziert. Dies gilt sowohl für Verbindungen innerhalb des Moduls wie auch für Verbindungen außerhalb.

Nicht zuletzt werden durch die Einsparung an Bauhöhe und -fläche natürlich auch Kostenvorteile realisierbar.

Realisiert man gemäß einer vorteilhaften Weiterbildung der vorliegenden Erfindung diejenigen der weiteren Komponenten, an denen hohe Spannungen anliegen, in einer Silicon-on-Insulator-Technik (SOI) und die Ansteuerschaltung in herkömmlicher Siliziumtechnik, so kann eine Verringerung der Baugröße erzielt werden, da die Abstände zwischen den hohe Spannungen führenden Teilen nochmals verringert werden können. Ohne SOl muss man z. B. bei vier Gleichrichterdioden jeden der vier Dies auf verschiedene Flächen eines Leadframes aufsetzen. Diese Flächen müssen etwas größer sein als der entsprechende Die. In SOI-Technologie kann man die vier Dioden in einem einzelnen Die verwirklichen und der zusätzliche Platzbedarf für die Flächen auf dem Leadframe einschließlich der Isolationsabstände dazwischen entfällt.

Die vorteilhaften Eigenschaften der erfindungsgemäßen Schaltungsanordnung kommen besonders beim Einsatz in einem primärgesteuerten Schaltnetzteil zum Tragen.

Anhand der in den beiliegenden Zeichnungen dargestellten Ausgestaltungen wird die Erfindung im Folgenden näher erläutert. Ähnliche oder korrespondierende Einzelheiten der erfindungsgemäßen Schaltungsanordnung sind in den Figuren mit denselben Bezugszeichen versehen. Es zeigen:
- Figur 1: einen Schaltplan einer primärseitigen Schaltungsanordnung für ein Schaltnetzteil;
- Figur 2: eine erfindungsgemäße aktive primärseitigen Schaltungsanordnung auf einem Schaltungsträger gemäß einer ersten Ausführungsform;
- Figur 3: eine zweite vorteilhafte Ausführungsform mit monolithisch integriertem Brückengleichrichter;
- Figur 4: eine maßstäbliche Gegenüberstellung der Ausführungsformen aus Figuren 2 und 3 zum Größenvergleich;
- Figur 5: eine dritte Ausführungsform der erfindungsgemäßen Schaltungsanordnung.

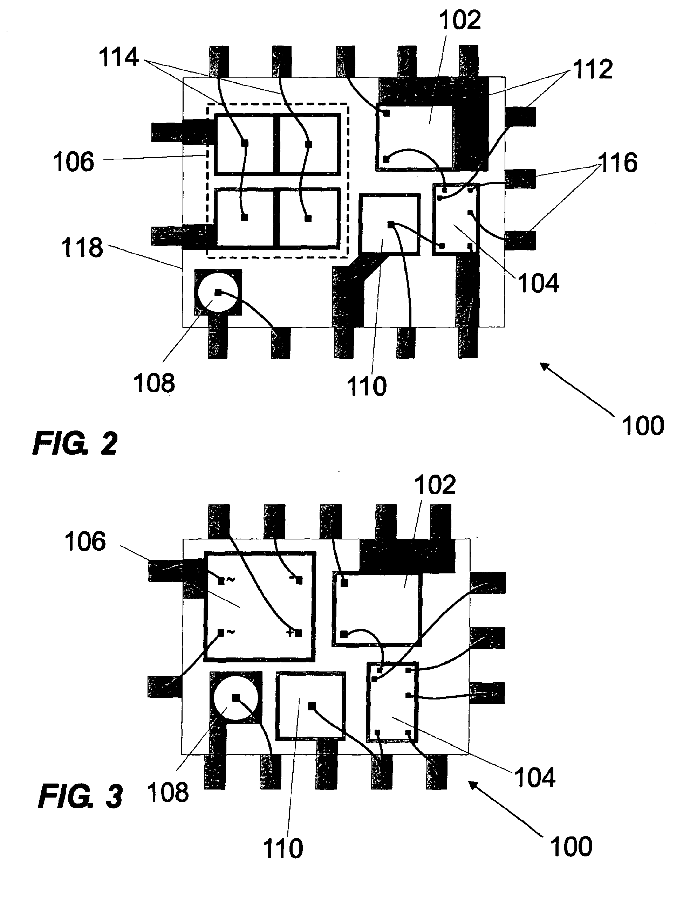

Mit Bezug auf die Figuren, und insbesondere auf Figur 2, soll eine erste Ausführungsform der erfindungsgemäßen aktiven primärseitigen Schaltungsanordnung 100 näher erläutert werden. In der gezeigten Ausführungsform wird die erfindungsgemäße Schaltungsanordnung beispielhaft als sogenannte "Micro Leadframe Package"-Komponente (MLP-Komponente) realisiert. Als Schaltungsträger fungiert hier ein Leadframe 112, das beispielsweise aus einer Kupferlegierung bestehen kann. Die einzelnen Halbleiterbausteine werden auf die jeweiligen dafür vorgesehenen Flächen des Leadframes 112 geklebt oder gelötet und mittels Bonddrähten 114 entsprechend kontaktiert.

Der Vorteil der MLP-Technik besteht unter anderem darin, dass äußerst geringe Abmessungen unter Verwendung konventioneller Kupfer-Leadframe-Technik erreicht werden können. Gleichzeitig können die elektrischen und thermischen Eigenschaften verbessert werden.

Als gemeinsames Gehäuse, das schematisch mit der Bezugsziffer 118 gedeutet ist, wird eine Vergussmasse, beispielsweise ein Epoxidharz, um die Anordnung gespritzt.

Selbstverständlich können die erfindungsgemäßen Prinzipien aber auch für andere Gehäuse- und Schaltungsträgertechnologien eingesetzt werden. Beispielsweise können keramische Schaltungsträger, flexible Schaltungsträger, Ball-Grid-Arrays oder dergleichen eingesetzt werden.

In der in Figur 2 gezeigten Ausführungsform liegen der Schalttransistor 102, die auch als Steuer-IC bezeichnete Ansteuerschaltung 104 sowie die Snubber-Diode 110, die Dioden für den Brückengleichrichter 106 und die Diode für die Hilfsspannungsversorgung 108 zunächst als einzelne Halbleiterchips, auch als Die bezeichnet, vor. Auf dem Leadframe 112 sind entsprechende Flächen vorhanden, um die verschiedenen Halbleiterchips aufnehmen zu können. Über diese Flächen kann eine einzelne Kontaktierung des Halbleiterchips zu den äußeren Anschlüssen 116 des Moduls hergestellt werden. Über Bonddrähte 114 können alle weiteren Kontaktierungen der Halbleiterchips zu den äußeren Anschlüssen 116 des Moduls hergestellt werden. Diese Bonddrähte 116 können beispielsweise aus Gold als sogenannte Thermo-Ultraschall-Bondverbindungen hergestellt werden.

Teilweise sind durch die Schaltungstopologie Verbindungen zwischen den im Modul verwendeten Bauteilen, beispielsweise zwischen dem Steuer-IC 104 und dem Schalttransistor 102, vorgegeben. Diese können bei der Herstellung durch interne Bonddrähte hergestellt werden. Dadurch vereinfacht sich das Layout einer hier nicht dargestellten Leiterplatte, auf welcher das Modul später aufgebracht wird.

Bei der Auslegung des Leadframes 112 muss grundsätzlich auf Spannungsdifferenzen und eine entsprechende Isolierung sowie auf ausreichende Wärmeableitung geachtet werden. Teile der erfindungsgemäßen Schaltungsanordnung 100, an denen hohe Spannungen anliegen, beispielsweise der Brückengleichrichter 106, und Teile mit geringeren Spannungen, z. B. die Diode für die Hilfsspannung 108, müssen entsprechend räumlich getrennt oder elektrisch isoliert angeordnet werden.

Für Bauteile, die eine große Kühlfläche benötigen, kann auf dem Leadframe 112 eine entsprechend große Metallfläche vorgesehen sein. Dies ist beispielsweise für den Schalttransistor 102 in Figur 2 gezeigt. Diese Metallfläche des Leadframes 112 kann auch nach unten offen aus dem hier nicht dargestellten Gehäuse der Schaltungsanordnung geführt werden und direkt auf der Leiterplatte zum Liegen kommen, so dass eine gute thermische Anbindung an die Leiterplatter erreicht wird.

Gegebenenfalls können auch mehrere äußere Anschlüsse 116 für eine internen Anschluss verwendet werden, um die Stromtragfähigkeit des entsprechenden internen Anschlusses zu erhöhen.

Eine weitergehende Miniaturisierung der Gesamtanordnung kann durch zusätzliche monolithische Integration mehrerer Bauteile innerhalb der Schaltungsanordnung 100 erreicht werden. Figur 3 zeigt eine Ausführungsform, bei der anstelle der vier Einzeldioden des Brückengleichrichters eine integrierte Brückengleichrichterschaltung 106 vorgesehen ist. Anstelle der in Figur 2 gezeigten vier einzelnen Diodenchips sind alle vier Dioden in einer Silicon-on-Insulator (SOI)-Technik auf einem Die integriert. Mit Hilfe dieser Technologie kann eine weitere Miniaturisierung des Moduls 100 erreicht werden, da sich durch die monolithische Integration eine kompaktere Bauweise der einzelnen Bestandteile der Schaltung ergibt.

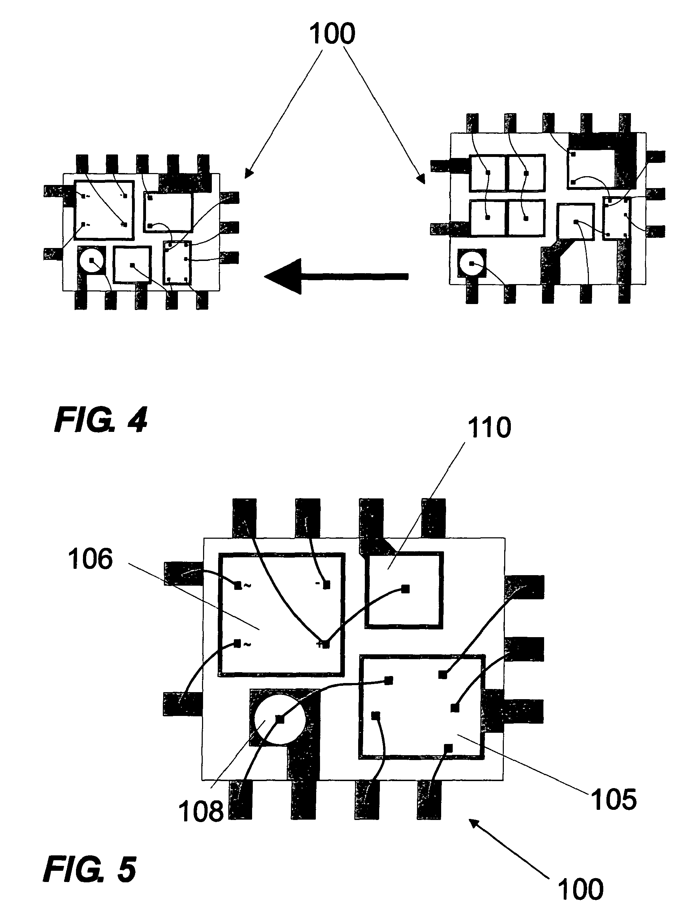

Ein Vergleich der Größenverhältnisse ist in Figur 4 durch maßstäbliche Gegenüberstellung der Schaltungsanordnungen 100 aus Figur 2 und Figur 3 gezeigt. Durch die Verwendung eines monolithisch integrierten Bauteils für den Brückengleichrichter 106 kann die benötigte Fläche von ca. 20 mm² auf ca. 12 mm² verringert werden.

Werden weitere Bauteile zusammengefasst, beispielsweise die Ansteuerschaltung 104 und der Schalttransistor 102, gelangt man zu einem Aufbau wie er in Figur 5 dargestellt ist. Die Abmessungen können hier noch weiter reduziert werden, indem einerseits die benötigte Fläche nochmals geringer wird, weil an Stelle der Einzelchips 102 und 104 aus Figur 2 ein einzelner IC 105 verwendet wird, und weil insbesondere auch eine Verringerung der Anzahl der internen Verbindungen über Bonddrähte auftritt. Dieser Wegfall interner Bonddrähte erhöht darüber hinaus auch die Zuverlässigkeit der gesamten Schaltungsanordnung.

Mit Hilfe der erfindungsgemäßen Integration der aktiven primärseitigen Komponenten auf einem Schaltungsträger und in einem einzigen Gehäuse wird also zum einen der benötigte Bauraum signifikant verringert, zum anderen kann durch die fortgesetzte monolithische Integration der verwendeten Bauteile eine zusätzliche Miniaturisierung erreicht werden. Neben der Einsparung an Bauraum ist außerdem eine deutliche Erhöhung der Zuverlässigkeit des gesamten Bauteils möglich.

Die erfindungsgemäße Schaltungsanordnung kann selbstverständlich sowohl als für die Oberflächenmontagetechnik geeignetes SMD (Surface Mounted Device), wie auch als bedrahtetes Bauelement für die konventionelle Durchsteckmontagetechnik ausgeführt sein.

## Patentansprüche

1. Schaltungsanordnung für ein Schaltnetzteil, wobei das Schaltnetzteil eine Primärseite, die mit einer Versorgungsspannung verbindbar ist, und eine Sekundärseite, die mit einem Verbraucher verbindbar ist, aufweist,
wobei die Schaltungsanordnung (100) einen primärseitigen Schalter (102), eine Ansteuerschaltung (104) zum Ansteuern des primärseitigen Schalters (102) und weitere aktive primärseitige Komponenten (106, 108, 110) umfasst,
wobei die Ansteuerschaltung (104) durch einen ersten integrierten Halbleiterchip gebildet ist und der primärseitige Schalter (102) sowie die weiteren Komponenten (106, 108, 110) in mindestens einem von der Ansteuerschaltung getrennten weiteren Halbleiterchip integriert sind, der mit der Ansteuerschaltung auf einem gemeinsamen Schaltungsträger (112) angeordnet ist.

2. Schaltungsanordnung nach Anspruch 1, wobei die Ansteuerschaltung (104), der primärseitige Schalter (102) und die weiteren aktiven primärseitigen Komponenten (106, 108, 110) in einem gemeinsamen Gehäuse (118) untergebracht sind.

3. Schaltungsanordnung nach Anspruch 2, wobei das Gehäuse (118) als bedrahtetes Gehäuse ausgeführt ist.

4. Schaltungsanordnung nach Anspruch 2, wobei das Gehäuse (118) als oberflächenmontierbares Gehäuse für die Surface-Mount-Technologie ausgeführt ist.

5. Schaltungsanordnung nach mindestens einem der vorangegangenen Ansprüche, wobei der Schaltungsträger als Leadframe (112) ausgeführt ist.

6. Schaltungsanordnung nach mindestens einem der vorangegangenen Ansprüche, wobei eine Metallisierung des Schaltungsträgers (112) Kühlbereiche aufweist, die zum Abführen von Wärme ausgebildet sind.

7. Schaltungsanordnung nach mindestens einem der vorangegangenen Ansprüche, wobei die weiteren aktiven Komponenten vier Gleichrichterdioden (106) umfassen.

8. Schaltungsanordnung nach mindestens einem der vorangegangenen Ansprüche, wobei die weiteren aktiven Komponenten eine Diode (108) zur Hilfsspannungsversorgung umfassen.

9. Schaltungsanordnung nach mindestens einem der vorangegangenen Ansprüche, wobei die weiteren aktiven Komponenten eine Snubber-Diode (110) umfassen.

10. Schaltungsanordnung nach mindestens einem der vorangegangenen Ansprüche, wobei die weiteren aktiven Komponenten (106, 108, 110) wenigstens teilweise zu einem einzelnen Halbleiterchip zusammengefasst und monolithisch integriert sind.

11. Schaltungsanordnung nach mindestens einem der vorangegangenen Ansprüche, wobei zumindest diejenigen der weiteren Komponenten (106, 108, 110), an denen hohe Spannungen anliegen, in einer Silicon-on-Insulator-Technik ausgeführt sind und die Ansteuerschaltung (104) als Silizium-Halbleiterschaltung ausgebildet ist.

12. Schaltungsanordnung nach mindestens einem der vorangegangenen Ansprüche, wobei der Schaltungsträger ein Mehrlagenkeramiksubstrat aufweist.

13. Schaltnetzteil mit einer Schaltungsanordnung (100) nach mindestens einem der Ansprüche 1 bis 12.
